# EUROPEAN PATENT SPECIFICATION

(11) **EP 1 460 643 B1**
(45) Date of publication and mention of the grant of the patent: **07.01.2009**
(21) Application number: 04101138.8
(22) Date of filing: 19.03.2004
(51) Int. Cl.: G21K 4/00, C30B 23/00, C30B 25/18, C23C 14/56, C23C 14/24, C23C 16/22, C09K 11/08

(54) **Manufacturing method of phosphor or scintillator sheets and panels suitable for use in a scanning apparatus.**
Herststellungsverfahren für Phosphor- oder Szintillatorfolien und Platten geeignet für eine Abtastvorrichtung
Procédé de fabrication de feuilles en phosphore ou de feuilles de scintillateur et panneaux utilisables dans un dipositif de balayage

(30) Priority: 20.03.2003 EP 03100723
(43) Date of publication of application: 22.09.2004
(73) Proprietor: Agfa HealthCare NV, 2640 Mortsel (BE)
(72) Inventor: Verreyken, Guido, 2640 Mortsel (BE); Bluys, Peter, 2640 Mortsel (BE); Hendrickx, Rudy, 2640 Mortsel (BE); Peeters, Lucas, 2640 Mortsel (BE); Lamotte, Johan, 2640 Mortsel (BE)
(74) Representative: Theunis, Patrick

(56) References cited:
- EP-A- 1 113 458
- WO-A-01/03156
- WO-A-87/06626
- US-A- 5 055 681
- US-A- 5 196 100

## Description

### FIELD OF THE INVENTION

The present invention relates to a particular method of continuously, on-line coating of a layer from a vapour flow of raw materials on a flexible substrate. More particularly the present invention relates to the manufacturing or production of scintillator or phosphor sheets, used in screens, panels or plates suitable for use in high energy radiation detection and imaging and, more particularly, in computed radiography, screen/film radiography and direct radiography.

### BACKGROUND OF THE INVENTION

In radiography the interior of objects is reproduced by means of penetrating radiation, which is high energy radiation also known as ionizing radiation belonging to the class of X-rays, µ-rays and high-energy elementary particle rays, e.g. µ-rays, electron beam or neutron radiation.

For the conversion of penetrating radiation into visible light and/or ultraviolet radiation "luminescent" substances, called "phosphors", are used. Cathodoluminescent phosphors employed e.g. in CRT screens exhibit two related luminescent characteristics: fluorescence and phosphorescence. Fluorescence is the luminescent build-up or emission of light released from the phosphor during the time of electron beam excitation. Phosphorescence is the emission of light from the phosphor occurring after the cessation of electron beam excitation. The duration of phosphorescence, or rate of decay of afterglow, is denoted as persistence, usually expressed as a measurement of time required for the phosphorescence in order to reduce or decay to a ten percent level of steady state fluorescent brightness.

In known X-ray image intensifiers for example as disclosed in US-A 3,838,273, the input screen comprises a substrate such as glass or aluminum on which is deposited an X-ray sensitive radiation conversion layer, commonly referred to as a fluorescence layer or scintillator.

In a conventional radiographic system an X-ray radiograph is obtained by X-rays transmitted imagewise through an object and converted into light of corresponding intensity in a so-called intensifying screen (X-ray conversion screen) wherein phosphor particles absorb the transmitted X-rays and convert them into visible light and/or ultraviolet radiation to which a photographic film is more sensitive than to the direct impact of X-rays. In practice the light emitted imagewise by said screen irradiates a contacting photographic silver halide emulsion layer film which after exposure is developed to form therein a silver image in conformity with the X-ray image.

As described e.g. in US-A 3,859,527 an X-ray recording system has meanwhile been developed wherein photostimulable storage phosphors are used having, in addition to their immediate light emission (prompt emission) on X-ray irradiation, the property to store temporarily a large part of the X-ray energy. Said energy is set free by photostimulation in the form of fluorescent light different in wavelength from the light used in the photostimulation. In said X-ray recording system the light emitted on photostimulation is detected photoelectronically and transformed into sequential electrical signals. A storage screen or panel coated with such phosphors is exposed to an incident pattern-wise modulated X-ray beam and as a result thereof energy is temporarily stored in the coated storage phospors, corresponding with the X-ray radiation pattern. At some interval after the exposure, a beam of visible or infra-red light scans the panel in order to stimulate the release of stored energy as light that is detected and converted to sequential electrical signals which are processed to produce a visible image. Stimulation light can be transformed into an electric signal by making use of a photoelectric conversion element such as e.g. a photo-multiplier. It is clear that the phosphor should store as much as possible of the incident X-ray energy and emit as little as possible of the stored energy until stimulated by the scanning beam. This is called "digital radiography" or "computed radiography".

Recently, in the hospitals the tendency is increasing to obtain X-ray images on computer monitor immediately after X-ray exposure of the patient. By storing and transmitting that digitized information efficiency and speed of diagnosis is enhanced. Accordingly "direct radiography" providing directly digital diagnostic X-ray images, after exposure of an adapted detector panel in a radiographic apparatus, becomes preferred instead of the conventional screen/film system. The X-ray quanta are transformed into electric signals by making use of a solid-state flat detector as "image pick-up" element. Such a flat detector is commonly called a "flat panel detector" and is two-dimensionally arranged. Making use therein of a photoconductive material as a detecting means, such as a-Se, in which the negative electrical charge of an electron and the positive electrical charge of a hole are generated by the X-ray energy, said X-ray energy is directly converted into those separated electrical charges. The electrical charge thus obtained is read out as an electric signal by the read-out element, two-dimensionally arranged in a fine area unit.

Furtheron an indirect type flat panel detector is known, in which the X-ray energy is converted into light by a scintillator, and in which the converted light is converted into the electric charge by the photoelectric conversion element such as a-Si two-dimensionally arranged in a fine area unit. The electrical charge is read out again as an electric signal by the photoelectric conversion read-out element, two-dimensionally arranged in a fine area unit.

Moreover a direct radiography detector is known in which the X-ray energy is converted into light by a scintillator, and wherein the converted light is projected on one or more CCD or CMOS sensors which are arranged matrix-wise in the same plane, through a converging body such as a lens or optical fiber. In the inside of the CCD or CMOS sensor, via photoelectric conversion, and charge-voltage conversion, an electric signal is obtained in every pixel. This type of detector is also defined, therefore, as a solid state plane detector.

The image quality that is produced by any radiographic system using phosphor screen or panel, and more particularly, within the scope of the present invention, in a digital radiographic system, largely depends upon the construction of the phosphor screen. Generally, the thinner a phosphor screen at a given amount of absorption of X-rays, the better the image quality will be. This means that the lower the ratio of binder to phosphor of a phosphor screen, the better the image quality, attainable with that screen or panel, will be. Optimum sharpness can thus be obtained when screens without any binder are used. Such screens can be produced, e.g., by physical vapour deposition, which may be thermal vapour deposition, sputtering, electron beam deposition or other of phosphor material on a substrate. Such screens can also be produced by chemical vapour deposition. However, this production method can not be used to produce high quality screens with every arbitrary phosphor available. The mentioned production method leads to the best results when phosphor crystals with high crystal symmetry and simple chemical composition are used. So in a preferred embodiment use of alkali metal halide phosphors in storage screens or panels is well known in the art of storage phosphor radiology and the high crystal symmetry of these phosphors makes it possible to provide structured, as well as binderless screens.

It has been disclosed that when binderless screens with an alkali halide phosphor are produced it is beneficial to have the phosphor crystals deposited as some kind of piles or pillar-shaped blocks, needles, tiles, etc., in order to increase the image quality that can be obtained when using such a screen. In US-A 4,769,549 it is disclosed that the image quality of a binderless phosphor screen can be improved when the phosphor layer has a block structure, shaped in fine pillars. In US-A 5,055,681 a storage phosphor screen comprising an alkali halide phosphor in a pile-like structure is disclosed. In EP-A 1 113 458 a phosphor panel provided with a selected vapour deposited CsBr:Eu phosphor layer is disclosed, wherein the binderless phosphor is present as fine needles in favour of an optimized image quality.

It is clear that, from a point of view of homogeneity of layer thickness and chemical composition of the scintillator, in favour of a constant speed, image quality and diagnostic reliability, it is of utmost importance to provide said constant composition and layer thickness over the whole two-dimensional panel surface in the production of the storage phosphor plates. A homogeneous coating profile should thus be strived for.

Manufacturing procedures making use of deposition techniques as in US-A 4,449,478 wherein an arrangement for coating substrates in an apparatus for vacuum deposition comprises a rotatable substrate holding structure in a form of a plate, provide coated panels limited in number and in coated surface. Moreover, when square or rectangular panels are desired, quite a lot of expensive residue is created while not being deposited onto the plate, rotating with a circular symmetry above the vapour source. In addition, when depositing material from a fixed source onto such a rotating substrate, it is difficult to obtain a layer with a constant thickness. Circles on the substrate, having the rotation axis as centre will have identical deposition history. This creates a centre-symmetric thickness profile, which means that the thickness of the deposited layer is constant along neither of the sides of a rectangular substrate, unless special precautions are taken, e.g. use of a mask which will however lead to material losses.

Manufacturing procedures making use of deposition techniques as in US-Application 2003/0024479 wherein an arrangement for coating rigid substrates, batch wise (plate per plate) in an apparatus for vacuum deposition comprises a substrate holder conveyed from a loading chamber to an unloading chamber by a conveying mechanism, provide coated panels limited in process yield. Another batch process has been described in US-A 6,402,905, where commonly a vapour deposition coating process is applied by which vapour is deposited onto a substrate that rotates around one axis that is perpendicular to the deposition area, as commonly applied in the state of the art, and wherein a system and method for controlling and compensating unevenness of the deposition thickness distribution on a substrate has been described.

In such a batch process a coating failure will generally lead to the complete loss of a panel. Moreover there will always be a high loss of raw materials in such batch processes.

Lack of deformability of the substrate also limits the format of the coating of a phosphor or scintilator layer on a substrate to the largest cross section of the vacuum deposition chamber. A solution in order to provide a method for producing phosphor or scintillator plates or panels, wherein the layer thickness in the manufacturing process is constant over large surface areas, so that phosphor plates of differing tailor-made sizes are available, has been given in EP-Application No. 03 100 723, filed March 20, 2003. That process was resulting in a high process yield from the same deposition process, thus providing a method for producing phosphor or scintillator plates or panels on very large flexible substrates, cutting these large areas in desired formats and protecting these flexible plates or panels against physical, chemical or mechanical damage, or a combination thereof. Although many measures have been described therein, it is of utmost importance to have the panel free from dust or dirt, in favour of diagnostic imaging quality, more particularly when screens, plates or panels ready-for-use in a scanning apparatus in computed radiography, screen/film radiography and direct radiography of all formats are envisaged.

### OBJECTS AND SUMMARY OF THE INVENTION

Therefore it is an object of the present invention to provide a method to prepare phosphor or scintillator plates, wherein said plates, prepared from large area plates, show further improved homogeneity in speed and sharpness over the whole area of the said large area plates, and wherein, irrespective of their dimensions when ready-for-use, those plates or panels are free of defects, due to dust or dirt, generated during vapour deposition and/or afterwards after cutting into plates having the desired dimensions.

Other objects will become apparent from the description hereinafter.

The above-mentioned advantageous effects have been advantageously realized by a particular manufacturing method having the specific features set out in claim 1. Specific features for preferred embodiments of the invention are set out in the dependent claims and in the drawings.

Further advantages and embodiments of the present invention will become apparent from the following description and drawings.

### BRIEF DESCRIPTION OF THE DRAWINGS

Following Figures represent an illustration of different embodiments of configurations related with the substrate to be coated and the apparatus wherein the coating process takes place. It is clear that these Figures, showing preferred embodiments of the coating methods according to the present invention, are in no way limited thereto.

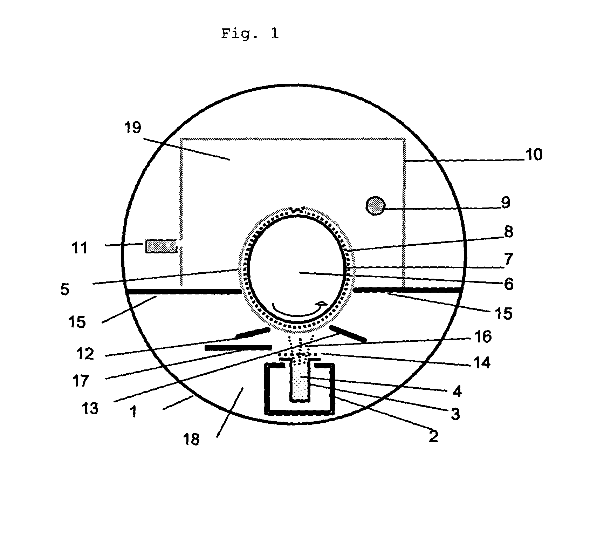

Fig. 1 is known from EP-A 1 460 642 and shows, as a comparative arrangement, a cylindrical vacuum chamber (1), containing an electrically heated oven (2) and a refractory crucible, tray or boat (3) containing a mixture of raw materials (4) which should be vaporized in order to be deposited onto a flexible sheet (5). The flexible sheet (5) is supported by a cooled - supporting - roller (6), thermally isolated from said flexible sheet (5) by a thermal isolation layer (7) and by heat-resisting coiled springs (8) mounted circumferentially onto said cylinder, further interconnecting both ends of said flexible sheet (5). Heating of said flexible sheet (5) proceeds by means of infrared heater (9) and reflector cage(10). Pyrometer (11) allows measurement of the temperature. The flexible sheet (5) is moving continuously or discontinuously in a forward direction through a vapour stream (16) provided by the heated mixture of raw materials (4) as a source for said vapour stream (16). Baffles (12) and (13) restrict vapour deposition to a selected part of sheet (5), mounted onto the roller (6). Refractory boat or tray (3) is covered with metallic raster (14), which avoids formation of pits (and unevenness) on the coated phosphor layer, deposited onto the flexible sheet (5). A cooled baffle (17) may be moved to shut off the surface to be coated from or expose the surface to be coated to the vapour stream. Optionally there can be a separation (15) between the evaporation part (18) and the heating part (19).

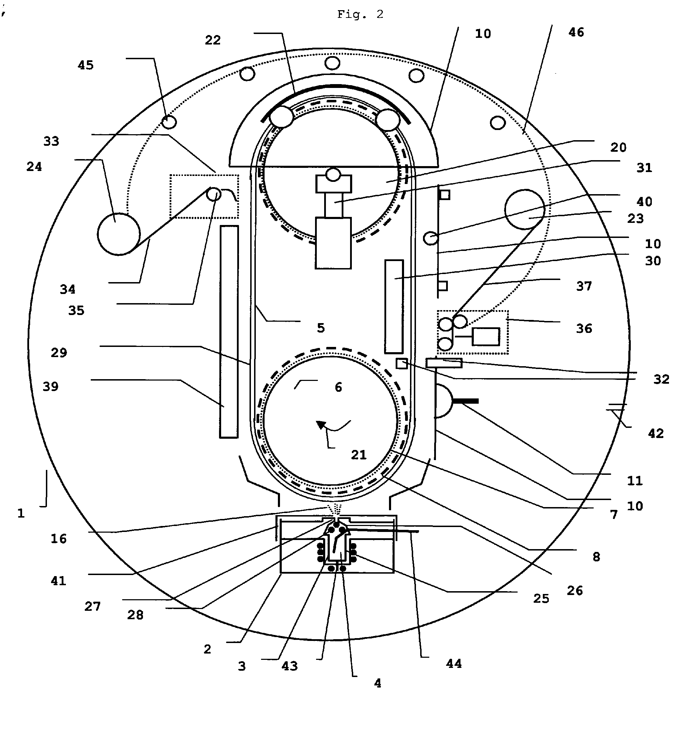

Fig. 2 as inventively improved arrangement shows a sealed zone acting as vacuum chamber (1), a flexible sheet(5) that is stretched around two conveying rollers, roller (6) being the lower and roller (20) being the upper conveying roller, moving in a direction as indicated by the arrow (21), through a vapour stream (16), provided by the mixture of raw materials (4) present in the crucible, tray or boat (3) provided with a container (25), an internally heated chimney (26) and a controllable outlet (27), heated to provide a vapour source generating said vapour stream (16), in order to provoke a phosphor layer to be deposited onto the flexible sheet (5) passing the vapour stream in (preferably continuous) multiple successive steps, wherein the flexible sheet (5) does not leave the vacuum chamber (1) and wherein at least during said step of vapour deposition the sealed zone is maintained under vacuum conditions. It is clear that the illustration is not limitative and that many configurations are possible within the space of the vacuum chamber(1) as has already been set out in the previously filed from EP-Application No. 03 100 723, dated March 20, 2003.

Particular parts present in order to reach the object of avoiding dust or dirt are the protecting foil (29) of substrate support (5) that is removed, when present on the flexible substrate support sheet (5) before vapour depositing the phosphor or scintillator layer. That protective foil is wound up and collected upon roller (24), before, optionally, applying corona discharge in order to further remove dust or dirt residues and before starting vapour deposition.

The suction table (30) acting as a means in order to position the substrate web onto the rollers, is further used to provide correct positioning of the protecting laminate foil (37) provided by unwinding roller (23) and applied via lamination unit (36) after phosphor or scintillator deposition. In a particular embodiment the laminate release foil (46) of a laminate package consisting of a laminate layer (37), a release foil (46) and an adhesive layer inbetween is guided over guiding rollers (45) and wound up over the same delamination collecting roller for the initial delaminate foil (29) present on the substrate support sheet (5).

Particular parts present in order to reach the object of further improving homogeneity of vapour deposition are the heating systems: besides those already mentioned in order to maintain the temperature within the crucibles at a level in order to avoid condensation of scintillator or phosphor material onto the walls of the chimney (26) a heat shield (41) with a slit in order to let the vapours pass therethrough acts as another source maintaining the temperature at the high desired level.

In favour of homogeneity of deposition another important part is the reflector cage (10) avoiding loss of heat within the sealed zone: its spatial arrangement has been optimized in order to avoid further excessive measures in favour of homogeneity of deposition and reproducibility. Nevertheless another important part is the cooling unit (39) providing an "off" and an "on" position in order to have sufficient heat in the support: once the phosphor starts to deposit the cooling is switched to an "on" position as substrate temperature increases, while further decrease while cooling is compensated by switching to an "off" position as will further be explained in the examples.

Controlling and steering parts as thermocouples (43) in contact with the outside crucible wall and (tantalum) protected thermocouples inside the crucible (44) under the raw phosphor or scintillator material level and in the vicinity of the lamps.

An important controlling part is the thickness measuring system (22), determining the thickness of the vapour deposited scintillator or phosphor layer, based on capacitance measurements.

Furtheron one or more pressure regulating cylinder(s) (31) for controll and regulation of tension on the substrate support sheet (5), during the whole procedure is present.

### DETAILED DESCRIPTION OF THE INVENTION

Within the scope of the present invention a method for coating is provided of a phosphor or a scintillator layer onto a flexible substrate, within a sealed zone maintained under vacuum conditions - also called "vacuum chamber" (1), by the step of vapour deposition in a coating zone onto said flexible substrate, wherein said phosphor or scintillator layer is, preferably continuously deposited onto said flexible substrate (5), in a configuration wherein said flexible substrate is mounted onto and guided over at least two rollers (6,20).

Within the scope of the present invention the term "flexible substrate" (5) has to be understood as "reversably deformable supporting or supported layer in form of a sheet, web or roller", the surface area of which has to be coated with a phosphor or scintillator material. Such a substrate is meant to be present as a flexible sheet or panel (5).

According to the method of the present invention a plurality of phosphor or scintillator sheets or panels having flexible supports or substrates (5) is provided by coating a phosphor or scintillator layer within a sealed zone, wherein said zone comprises at least two cylindrical carrier rollers (6,20) for carrying a flexible substrate (5) exceeding dimensional formats of desired scintillator sheets or panels with a factor of at least 5, wherein said cylindrical carrier rollers (6,20) each have an axis in a parallel arrangement with one another; wherein said zone comprises at least one crucible (3) containing a mixture of raw materials (4) providing desired phosphor or scintillator compositions for said layer; and wherein said zone comprises a laminating unit (36); wherein said method comprises the steps of mounting said flexible substrate (5) onto said carrier rollers (6,20), vapour depositing said phosphor or scintillator layer having a desired phosphor or scintillator composition onto said flexible substrate (5), and laminating said phosphor or scintillator layer by a laminating step, thereby covering said layer with a protective foil (37); further comprising the step of cutting said layer into sheets or panels having desired formats, and wherein at least during said vapour depositing step said zone is maintained under vacuum conditions as a vacuum chamber (1). Desired formats are e.g. well-known areas of 14" x 17" (35.6 cm x 43.2 cm) as being commercially available, but are in no way limited hereto.

In order to fully reach the objects of the present invention, accordingly said sealed zone further comprises a delaminating unit (33,34,35), and a step of delaminating said flexible substrate (5), when provided with an initial protective laminate foil (29), is included, before said step of vapour depositing said phosphor or scintillator composition.

According to the method of the present invention said steps of laminating said phosphor or scintillator layer and said step of delaminating said flexible substrate (5) are both performed under vacuum conditions.

As a substrate material use can be made of glass, a ceramic material, a polymeric material or a metal; more preferably a material selected from the group consisting of glass, polyethylene therephthalate, polyethylene naphthalate, polycarbonate, polyimide, aluminum, Pyrex^{®} , polymethylacrylate, polymethylmethacrylate, sapphire, zinc selenide, Zerodur^{®} , a ceramic layer and a metal or an alloy selected from the group of aluminum, steel, brass and copper. It should even not be limited thereto as in principle, any metal or synthetic material resisting irreversible deformation, e.g. as by melting, after addition of energy to the extent as commonly applied in the coating process of the present invention, is suitable for use. Particularly preferred as flexibly moving substrate (5) in method of the present invention is aluminum as a very good heat conducting material allowing a perfect homogeneous temperature over the whole substrate (5). As particularly useful aluminum substrates, without however being limited thereto, brightened anodized aluminium, anodized aluminium with an aluminium mirror and an oxide package and, optionally, a parylene layer; and anodized aluminium with a silver mirrror and an oxide package and, optionally, a parylene layer; available from ALANOD, Germany, are recommended.

So according to the method of the present invention said flexible substrate support (5) is an anodised aluminum support layer, covered with a protective foil (46).

According to the method of the present invention said anodised aluminum support layer (5) has a thickness in the range of from 50 to 500 µm, and more preferably in the range from 200 to 300 µm. Such an anodized aluminum substrate has shown to be particularly favourable with respect to adhesion characteristics with respect to vapour deposited phosphors or scintillators and even bending of that flexible aluminum support coated with a scintillator layer having a thickness of 500 µm up to 1000 µm, does not cause "cracks" or delamination of scintillator or phosphor "flakes": no problems have indeed been encountered with respect to occurrence of undesirable cracks when prepared according to the method of the present invention.

The mounting step preferably proceeds by means of a suction table (30) wherein tension controll on the flexible substrate proceeds by regulating (air) pressure cylinders (31) that push up one roller in case of a configuration with 2 rollers, one (upper) roller present above the other (lower) roller.

According to the method of the present invention in said mounting step two ends of the substrate support (5) are glued together with a heat resistant adhesive, with one or more (e.g. a couple of) rivets or with a combination thereof.

According to the method of the present invention one carrier roller (6) is rotating, in a controlled way, by means of a motor around its axis, whereas other roller(s) (20) is(are) rotating by movement of said one roller; and wherein while rotating, the position of the flexible substate (5) on the rollers is controlled by means of an optical positioning sensor (32), coupled back to pressure regulating cylinder(s) (31), providing position adjustment of said flexible substrate (5).

According to the method of the present invention said protective laminate foil (29), initially laminated onto the said flexible substrate (5), is removed in said delaminating step, once said flexible substrate (5) has been put on tension.

According to the method of the present invention said protective laminate foil (29) is removed under vacuum by delamination, making use of a delamination unit (33,34,35) present in the vacuum chamber (1). Said foils are e.g. polymeric foils as e.g. polyethylene foils, polyimide foils and polyester foils,without however being limited thereto.

According to the method of the present invention said carrier rollers (6,20) are thermally isolated from said flexible substrate support (1) by means of a thermal isolation layer (7) and/or a plurality of heat-resistant coiled springs (8), mounted over the length of the cylinders (6,20) in such a way that the said coiled springs (8) make an angle in the range of 20° to 40° with a line, parallel with the axis of said cylindrical carrier rollers (6,20). More preferably, said coiled springs (8) make an angle in the range of 25° to 35°, and even more preferably an angle of about 30° is envisaged.

The more space is left free in the vacuum chamber (1), the more controll sites are available. Free space can be provided e.g. with heat controlling means and sensors for temperature controll at different sites, with regard to optimize homogeneous vapour deposition onto the moving flexible support (5). Otherwise, means in order to locally enhance the temperature, by heating as e.g. by infrared radiation (9), is provided in the vacuum chamber (1), where free space allows such installation (e.g. in the neighbourhood of the rollers, or whatever a critical site within the vacuum chamber (1)).

According to the method of the present invention during said vapour depositing step the temperature of the said flexible substrate (5) is maintained in the range from 150°C to 300°C, more preferably in the range from 150°C to 250°C and still more preferably in the range from 180°C to 220°C, envisaging a target temperature of about 200°C, by means of regulable heaters (38,40) and by an adressable cooling unit (39) installed along the support. As heaters, infrared heaters are advantageously used. More particularly use is made of large quartz lamps, arranged horizontally, e.g. longitudinally, along the said substrate with a reflecting screen (10) behind it. A vertical arrangement is not excluded however. As additional infrared heaters at least two smaller quartz lamps with a reflecting screen (10) behind are used at the edges of the flexible substrate (5), in order to reduce temperature differences between the middle and the edges of said substrate (5). Said additional lamps are advantageously arranged in order to make an angle of about 60° with the large longitudinal quartz lamp. Furtheron a battery of small lamps is advantageously used, as described in an additional experiment in the examples hereinafter.

According to the method of the present invention said cooling unit (39) is build up of a black body cooling element, cooled with water at room temperature on the backside, and of an addressable (opened or closed) screen of louvers in form of multiple slats on the front or support side of said cooling element. In one embodiment thereof the said slats are placed with their long side along the moving direction of the support (5), partly overlapping each other, thereby providing ability to be reflective ("cooling-off") on the front side, and ability to become rotated altogether along their long axis ("cooling-on"). According to the present invention said temperature is measured and registrated and a temperature profile over the whole width of said flexible substrate (5) is used as input for steering substrate heating and/or substrate cooling.

According to the method of the present invention said temperature is measured over the whole width of said flexible substrate (5) by means of a set of pyrometers (38). In one embodiment said pyrometers (38) are lens based pyrometers with a parabolic reflector on top. In a preferred embodiment thereof said reflector is a gold evaporated mirror, wherein each focus of the said parabolic reflector is arranged in order to coincide with each focus of the corresponding pyrometer lens.

Means in order to controll layer thickness of deposited material are advantageously installed in order to stop the deposition process when the desired thickness is attained. So according to the method of the present invention said sealed zone further comprises as a controlling part a thickness measuring system (22), determining thickness while vapour depositing said scintillator or phosphor layer, wherein said measuring system is based on capacitance measurements.

According to the method of the present invention the said flexible substrate (5) is spatially surrounded by a reflector cage for heat radiation.

According to the method of the present invention said protective foil (37), provided by the step of laminating said foil after depositing said phosphor or scintillator layer is a temporary protection layer (46) removed by a delaminating step before or after cutting; or a lasting protective foil layer (37). Lamination steps advantageously make use of the suction tabel (30), already used before during positioning of the initial substrate web.

In a preferred embodiment delamination proceeds by making use of a delamination forerunner (34), mounted by means of one or more rollers (35) to a delamination upwinding roller (33). In another embodiment delamination proceeds by hooking or fastening the said protective laminate foil on the said delamination unit.

According to a further aspect of the method of the present invention, said protective foil (37), provided by the step of laminating said foil after depositing said phosphor or scintillator layer is a lasting protection layer, wherein said lasting protection layer is provided from a protection layer package (23), comprising a release layer (46) that is removed in a further delaminating step and that is wound up on an upwinding roller (24).

According to a particular embodiment thereof in the method of the present invention said protective foil (37), provided by the step of laminating said foil after depositing said phosphor or scintillator layer is a lasting protection layer, wherein said lasting protection layer is provided from a protection layer package (23), comprising a release layer (46) removed in a further delaminating step by means of the same delaminating unit (33,34,35) used during the delaminating step of said flexible substrate, when initially provided with a protective laminate foil (29). Such a protection layer in the lamination package is advantageously consisting of polymer layer with an adhesive layer at one side, and a release layer (46) at the other side. Preferred release layers, also called release liners, are e.g. siliconised polyethylene terephthalate release layers, in contact with an adhesive layer, whereas the protection foil is a polymer foil as, e.g. a polyethylene foil, a polyester foil or a polyimide foil, without however being limited thereto. The lamination package advantageously passes the laminate unit (36) with mechanism for supplying laminate foil and the protective foil is delaminated from the release layer (46) in order to become laminated onto the vapour deposited phosphor layer. As this operation advantageously proceeds in vacuum the phosphor layer remains free from dust and dirt, corresponding with the objects of the present invention. The release layer (46) is further guided over the guiding rollers (45) to the same delamination collecting roller as has been available for delamination of the initial laminate (29) present on the protected substrate support (5). It is clear that more particularly presence of an initial laminate (29) on the substrate support is envisaged in order to fully reach the objects of the present invention. So advantage is obtained by starting with e.g. a polyethylene protected anodised aluminum substrate support (5), without however limiting it thereto.

According to the method of the present invention cutting said flexible substrate (5), coated with a phosphor or scintillator layer into sheets or panels having desired formats, proceeds out of the vacuum chamber (1).

The method of the present invention is further characterized by the step of laminating said sheet or panel substrate (5) carrying said phosphor or scintillator layer onto a carrier layer.

According to the method of the present invention said carrier layer is selected from the group consisting of a flexible or rigid polymer layer, a glass support, a carbon fibre plate and a rigid metal sheet.

In a common arrangement within the sealed zone (1) under vacuum pressure (vacuum conditions corresponding with at least 10⁻¹ mbar, and even down to 10⁻⁴ mbar or less if attainable as in the preferred configuration of the coating apparatus), the container is one crucible (3), preferably as described hereinbefore and as illustrated in Fig.2. It is not excluded to make use of a plurality of crucibles, arranged in each direction of the two-dimensional, coated surface. Moreover it is recommended to make use of advantageous measures taken into account with respect to crucibles as described in EP-Applications Nos. 03 102 003 and 03 102 004, both filed July 4, 2003, published as US-Applications 2005/000411, 2005/000 447, 2005/000448 and 2005/051097.

It is evident that the composition of the raw material in the containers is chosen in order to provide a composition as desired, wherein said composition is determined by the ratios of raw materials present. Ratios of raw materials are chosen in order to provide the desired chemical phosphor or scintillator composition after deposition of the vaporized raw materials. It is desirable to mix the raw materials in order to get a homogeneous raw mix in the crucible(s) in form of solid powders, grains or granules, or as pastilles having a composition corresponding with the desired ratios of raw materials in order to provide the desired phosphor coated onto the moving substrate material. A milling procedure may be favourable in order to provide a high degree of homogeneity before vaporization and is therefore recommended. Differing components may also be vaporized from different crucibles, arranged in series or in parallel or in a combined arrangement as already suggested before, provided that a homogeneous vapour cloud is presented to the flexible substrate via the vapour stream or flow, deposited by condensation onto said substrate. Two elongated one-part boats having same or different raw material content or raw material mixtures may e.g. be present in series in the moving direction of the web. In another embodiment, if providing a more homogeneous coating profile, boats may be arranged in parallel on one axis or more axes, perpendicular to the moving direction of the support, provided that overlapping evaporation clouds again are providing a vapour stream that becomes deposited onto the support in a phosphor or scintillator layer having a homogeneous thickness, composition and coated amount of said phosphor or scintillator. Presence of more than one crucible (3) may be in favour of ability to supply greater amounts of phosphor or scintillator material to be deposited per time unit, the more when the flexible substrate (5) should pass the vapour flow at a rate, high enough in order to avoid too high temperature increase of the substrate. The velocity or rate at which the substrate passes the container(s) should indeed not be too slow in view of undesired local heating of the substrate support, making deposition impossible, unless sufficient cooling means are present in favour of condensation. The supporting or supported substrate should therefore preferably have a temperature between 50°C and 300°C in order to obtain deposited phosphor or scintillator layers having the desired optimized properties.

It is clear that energy should be supplied to one or more container(s), also known as crucible(s), tray(s) or boat(s) (3), in order to provoke a vapour flow (or stream) of the raw materials (4) present therein, which become vaporized in the sealed vacuum zone (1): energy is submitted thereto by thermal, electric, or electromagnetic energy sources. As an example of an electromagnetic energy source a diode, a cathodic arc, a laser beam, an electron beam, an ion beam, magnetron radiation or radio frequencies may be used, whether or not pulsed, without however being limited thereto. Electric energy is commonly provided by resistive heating, making use of resistance coils wound around the container(s) or crucible(s) in a configuration in order to get conversion into thermal energy, thereby providing heat transfer to the containers or crucibles filled with the raw materials that should be evaporated. Energy supply to an extent in order to heat the container(s) or crucible(s) up to a temperature in the range from 550-900°C is highly desired. At those temperatures, it is clear that containers should resist corrosion, so that refractory containers are preferred. Preferred container or crucible materials therefor are tungsten, tantalum, molybdenum and other suitable refractory metals. Energy supply as set forth heats the mixture of raw materials in the crucible to a temperature above 450°C, preferably above 550 °C, and even more preferably in the range of 550°C up to 900°C.

A cloud of vaporized material, originating from the target raw materials thus escapes as a cloud in form of a flow or stream from the container(s) or crucible(s) in the direction of the moving substrate, where a coated layer is formed by condensation. From the description above it is clear that, in order to obtain a homogeneous coating profile as envisaged, a homogeneous cloud can only be realized when homogeneity is provided in the bulk of the liquefied raw material. As a consequence, a homogeneous distribution of energy supplied over the container is a stringent demand. In a preferred embodiment, in favour of homogeneity, the crucible (3) is in form of a single elongated "boat" with a largest dimension corresponding with the width of the flexible support (5) moving over the said crucible so that at each point of its surface area the momentarily velocity magnitude is constant.

If required during or after the deposition process oxygen can be introduced into the vacuum deposition chamber (1) in form of oxygen gas via the argon gas inlet (42). More particularly an annealing step inbetween two deposition steps or at the end of the phosphor deposition may be benificial.

An important factor with respect to coating profile is the distance between container(s) (3) and moving substrate (5) as the distance determines the profile of the vapour cloud (16) at the position of the flexible substrate (5). Average values of shortest distances between crucible(s) (3) and substrate (5) are preferably in the range of from 5 to 10 cm. Too large distances would lead to loss of material and decreased yield of the process, whereas too small distances would lead to too high a temperature of the substrate (5). Moreover care should further be taken with respect to avoiding "spot errors" or "pits", resulting in uneven deposit of phosphors or scintillators, due to spitting of the liquefied raw materials (4) present in the heated container(s) (3). Measures taken therefore have been illustrated in Fig. 2 and also those described in EP-Applications Nos. 03 102 003 and 03 102 004, both filed July 4, 2003 and published as US-Applications 2005/000411, 2005/000 447, 2005/000 448 and 2005/051097, are advantageously applied.

According to the method of the present invention said step of vapour depositing said phosphor or scintillator compositions is initiated by a vapour flow (16) of raw materials (4) from one or more crucible(s) (3), and wherein said vapour flow (16) is generated by adding energy to said raw materials (16) and said container(s) (3), by thermal, electric, or electromagnetic energy or a combination thereof.

According to the method of the present invention said step of vapour depositing said phosphor or scintillator compositions proceeds by physical vapour deposition, by chemical vapour deposition or a by combination of physical and chemical vapour deposition.

In another embodiment said phosphor is a photostimulable phosphor and, even more preferred according to the coating process of the present invention, said photostimulable (storage) phosphor is a CsBr:Eu phosphor. Related therewith and particularly preferred in the coating process according to the present invention, although not limited thereto at all, said raw materials are CsBr and between 10⁻³ and 5 mol % of a Europium compound selected from the group consisting of EuX'₂, EuX'₃ and EuOX', X' being a halide selected from the group consisting of F, Cl, Br and I as has been used in the preparation method disclosed in PCT-filing WO 01/03156. Even more preferred is the binderless coating process according to the present invention of the selected CsBr:Eu phosphor from CsBr and EuOBr raw materials, wherein the said phosphor is characterized by its particular needle-shaped form. The high degree of crystallinity is easily analysed by X-ray diffraction techniques, providing a particular XRD-spectrum as has been illustrated in EP-A 1 113 458. Therefore a mixture of CsBr and EuOBr is provided as a raw material mixture in the crucibles, wherein a ratio between both raw materials normally is about 90 % by weight of the cheap CsBr and 10 % of the expensive EuOBr, both expressed as weight %. It has however been shown that as a function of coating (evaporating) temperature ratios can be adapted in favour of lower material and production cost, without resulting in changes in composition: so higher vaporization temperatures for the raw material mixture in ratio amounts of 99.5 wt% CsBr and 0.5 wt% EuOBr provide the same result as before.

The preferred CsBr:Eu²⁺ phosphor, obtained after vapour deposition as a needle-shaped phosphor, is characterized by voids between the needles. In order to fill those voids, measures can be taken as described in EP-A 1 347 460, wherein voids are partially filled with a polymeric compound; as in EP-A 1 349 177, wherein vapour deposited pigments like the preferred µ-Cu-phthalocyanine nanocrystalline dye compound are filling said voids or as in EP-1 453 065, wherein the voids are at least partially filled with polymeric compounds selected from the group consisting of silazane and siloxazane type polymeric compounds, mixtures thereof and mixtures of said silazane or siloxazane type polymeric compounds with compatible polymeric compounds. More particularly with respect to the said dyes or pigments, vapour deposition thereof can be performed in the vacuum deposition chamber used in the configuration of the production method according to the present invention.

In order to prepare sheets or panel provided with the preferred CsBr:Eu²⁺ phosphor, according to the method of the present invention said raw materials (4) comprise, as phosphor precursors, at least CsₓEuyX'_{x+αy}, wherein the ratio of x to y exceeds a value of 0.25, wherein µ ≥ 2 and wherein X' is a halide selected from the group consisting of Cl, Br and I and combinations thereof.

In another embodiment according to the method of the present invention said raw materials (4) comprise, as phosphor precursors, at least CsBr and CsₓEuyX'_{x+αy}, wherein the ratio of x to y exceeds a value of 0.25, wherein µ ≥ 2 and wherein X' is a halide selected from the group consisting of Cl, Br and I and combinations thereof.

Methods for preparing and coating desired CsBr:Eu phosphors, wherein use is made of precursors as set forth, have been described in EP-1 566 425 and EP-A 1568751 respectively.

According to the method of the present invention, at the moment of deposition, said phosphor or scintillator layer is a binderless layer. This can be well understood, as at those high temperatures, presence of additional binders besides phosphors or scintillators raw materials in the container(s) would not be practical. It is however not excluded to make use of polymers, showing ability to become vaporized, in order to serve as binder material e.g. between substrate and phosphor or scintillator layer or even between the preferred phosphor or scintillator needles in the coated layer. Moreover when laminating a polymer layer onto the deposited layer, it is not excluded that polymer material is filling, at least in part, the voids between those needles.

Furtheron it is not excluded to provide the phosphor or scintillator sheets or panels, before or after cutting in desired formats, with a moisture-resistant layer, in order to protect the moisture-sensitive phosphor layer against deterioration. Particularly preferred layers are e.g. parylene (p-xylylene) layers as described in EP-A 1 286 364, whether or not overcoated with a transparent organic layer of silazane or siloxazane type polymeric compounds or mixtures thereof as described in EP-A 1 453 066. In the method of applying a protecting parylene layer to phosphor or scintillator coatings as a "parylene layer" a halogen-containing layer was preferred. More preferably said "parylene layer" is selected from the group consisting of a parylene D, a parylene C and a parylene HT layer. In the particular case a cross-linked polymeric layer is advantageously formed on a phosphor screen material, wherein the said polymeric material layer has been formed by reaction of at least one component, thereby forming self-condensing polymers. Reactive monomers are provided in form of heated vapour in order to form the desired condensation polymer on the substrate, wherein said condensation polymer is in form of a p-xylylene or "parylene" layer on the phosphor screen substrate. Examples of these "parylene" layers are poly-p-xylylene (Parylene-N), poly-monochloro-p-xylylene (Parylene-C) and polydichloro-p-xylylene (Parylene-D). If desired a pigment can be integrated into a thin film of a poly-p-xylylene as has been described in JP-A 62-135520.

According to the method of the present invention said phosphor layer is a binderless layer of a photostimulable CsBr:Eu phosphor.

In another embodiment according to the method of the present invention said phosphor is a prompt emitting luminescent phosphor. Said luminescent phosphor is suitable for use e.g. in intensifying screens as used in screen/film radiography.

With respect to the specific application, related with CR and DR, it is clear that in view of image quality, and more particularly in view of sharpness, binderless phosphor or scintillator layers as described hereinbefore are preferred. With respect thereto it is clear that vaporization of raw materials in order to build the desired scintillators phosphors is a preferred technique, provided that, according to the present invention the layers have been deposited on a flexible substrate, as claimed, and wherein it is envisaged to deform the flexible support in order to get a flat sheet or panel, ready-for-use, suited for specific CR and DR applications. Other hygroscopic phosphor or scintillator layers besides the preferred CsBr:Eu phosphor that are advantageously prepared according to the method of the present invention are e.g. BaFCl:Eu, BaFBr:Eu and GdOBr:Tm, used in intensifying screens; CsI:Na applied in scintillator panels and storage phosphors suitable for use in computed radiography (CR) as e.g. BaFBr:Eu, BaFI:Eu, (Ba,Sr)F(Br,I):Eu, RbBr:Tl, CsBr:Eu, CsCl:Eu and RbBr:Eu; or CsI:Tl, which is particularly suitable for use in DR-cassettes.

While the present invention will hereinafter be described in connection with preferred embodiments thereof, it will be understood that it is not intended to limit the invention to those embodiments.

### Examples

### Comparative Example 1

This example describes the state-of-the art method performed in order to obtain a photostimulable CsBr:Eu imaging plate.

A CsBr:Eu photostimulable phosphor layer was deposited in a vacuum chamber via thermal vapour deposition on a flat rigid aluminum support that rotates around an axis perpendicular to and going through the centre of the support starting from a mixture of CsBr and EuOBr as raw materials. While rotating said support its momentary velocity magnitude is highest at the outside (at the boundary) of the support and zero in the centre of the support.

The support was heated with the aid of a resistively heated heating plate having a temperature of 240°C.

The support was aluminum having a thickness of 800 µm, a width of 18 cm and a length of 24 cm. The aluminum support was mounted, against a substrate holder, rotating in a controlled way by means of a motor, around its axis. The aluminum was rotating with an angular speed of 12 rotations per minute. The support was heated by means of a resistively heated heating plate at 240°C.

A mixture of CsBr and EuOBr, in a CsBr/EuOBr 99.5%/0.5% ratio by weight percentage was used as a raw material mixture to become vaporized and was placed in two containers. The distance between the containers and the substrate was about 15 cm. The containers were placed at the circumference of a circle described by an edge of the rotating substrate. The containers were covered with a cover plate having one slit therein and a guiding plate, guiding the vapour stream towards the substrate.

Under vacuum pressure (a pressure of 2x10⁻¹ Pa was maintained as an equilibrium between a continuous inlet of argon gas into the vacuum chamber and continuous pumping) and at a sufficiently high temperature of the vapour source (750°C) the obtained vapour was directed towards the rotating substrate and was deposited thereon.

A CsBr:Eu stimulable phosphor layer having an average thickness of 500 µm was deposited over the entire area of the support.

Only 13 % by weight of the evaporated material was deposited onto the support.

An area of 0.043 m², suitable for practical use, was obtained.

The stimulable phosphor layer shows a blue luminescence under UV radiation.

### Inventive Example 1

A CsBr:Eu photostimulable phosphor screen having a flexible anodised aluminum (5) was prepared in a vacuum chamber (1) by means of a thermal vapour deposition process, starting from a mixture of CsBr and EuOBr as raw materials (4). Said deposition process onto said flexible anodised aluminum support (5) was performed in such a way that said support (5) was moving so that the momentary magnitude of the velocity was constant over its whole area.

Referring to Fig. 2 the cylindrical vacuum chamber (1) with a diameter of 1.4 m and a length of 1.75 m was containing an electrically heated oven (2) and a refractory tray or boat (3) in which 4 kg of a mixture (4) of CsBr and EuOBr as raw materials in a 99.5%/0.5% CsBr/EuOBr percentage ratio by weight were present to become vaporized.

Crucible (3) was an elongated boat composed of "tantalum" having a thickness of 0.5 mm composed of 3 parts: a crucible container (25), an internally heated chimney (26) and a controllable outlet (27), the longitudinal parts of which are folded from one continuous tantalum base plate in order to overcome leakage. The chimney was provided with heaters (28) in order to heat the chimney in order to overcome condensation of vaporized materials. Moreover the chimney heaters (28) were positioned in a baffled way in order to overcome spatter of molten or vaporized material onto the substrate into an uncontrolled and unlimited way. A lip opening of 5 mm as controllable outlet (27) was used. A heat shield (41) with slit opening was further shielding heat in order to avoid escape of heat and loss of energy, required to provoke vapour escape and deposit onto the continuously moving substrate support in a controlled and uniform way.

Under vacuum pressure (a pressure of 2x10⁻¹ Pa equivalent with 2x10⁻³ mbar) maintained by a continuous inlet (42) of argon gas into the vacuum chamber (1), and at a sufficiently high temperature of the vapour source (760°C) and the chimney (26) the obtained vapour was directed towards the moving sheet support (5) and was deposited thereupon successively while said support was moving along the vapour stream (16). Said temperature of the vapour source was measured by means of thermocouples (43) present outside and pressed under the bottom of said crucible and tantalum protected thermocouples (44) present in the crucible and in the chimney (26). The anodised aluminum substrate support (5) having a thickness of 280 µm, a width of 1.04 m and a length of 2.50 m, together with a protection foil (29) was mounted onto the anodised side around two cylindrical support rollers (6)and (20), both having a diameter of 40 cm and a length of 1.18 m. The said anodised side was positioned at the side whereupon the phosphor should be deposited. The support (5) was correctly positioned by means of the suction table (30) that was present in the machine. The two ends of the support were glued together with a heat resistant adhesive and with one or more rivets. The tension on the support was further controlled by regulating the pressure on two cylinders (31) that push up the upper support roller (20). Such a system moreover avoids or compensates for a loss of tension during heating up the anodised aluminum support, due to thermal expansion of the support. The lower roller (6) was rotating in a controlled way by means of a motor around its axis, whereas the upper roller was rotating by means of the support, moving by the rotating lower roller (6). Under vacuum, during rotation, the position of the support on the rollers could be controlled by means of an optical positioning sensor (32)(placed in vacuum), coupled back to pressure regulating cylinder(s) (31) provided for pushing up the upper carrier roller (20). The anodised aluminum was moving with a constant linear velocity of 20 m per minute.

The lower cylindrical carrier roller (6) and the upper carrier roller (20) were thermally isolated from the substrate support sheet (5) by means of a thermal isolation layer (7) and by means of heat-resistant coiled springs (8), that were mounted over the length of the cylinder in such a way that the coiled springs make an angle of 30° with a line, parallel with the axis of the cylinder.

The protection foil (29) for the aluminum was removed once the support was on tension.

In another experiment it was removed under vacuum by making use of a delamination unit (33) present in the vacuum chamber (1). Delamination was made possible by the use of a delamination forerunner (34), mounted over one or more delamination rollers (35) to the delamination roller (24) on one side and connected to the protection foil (29) on the other side.

In still another experiment, the forerunner was hooked or fastened to the protection foil under vacuum.

Delamination of the protection foil under vacuum was particular advantageous in that there was no risk to get dust in the meantime become deposited onto the film before the vacuum cyclus was started.

In another experiment before vacuum deposition of the phosphor the anodized aluminium was treated with a corona discharge treatment over the whole width in order to further remove dirt, optionally present, as e.g. from residues of protection foil and/or from the substrate.

The temperature of the support (5) was maintained in the vicinity of 200°C (± 10°C ). The temperature was measured over the whole width of the roller with 5 pyrometers. In order to overcome misleading temperature measurements due to failures by measuring of heating effects by reflection of environmental heat radiation, use was made of lens based pyrometers with a parabolic reflector on top (38). In order to obtain a good reflection in the reflector a gold evaporated mirror was used. The focus of the parabolic reflector was directed in order to coincide with the focus of the pyrometer lens. The temperature of the substrate was regulated by means of regulable infrared heater(s) (40) and by an adressable cooling unit (39) installed along the support. As infrared heaters (40) use was made of quartz lamps. Those lamps were always adressed at full power in order to provide energy emission within a wavelength spectrum, matching the absorption spectrum of the aluminum substrate support. The effective heat radiation time was regulated by a 7 level time modulation regulation (regulation of the "on" and the "off" term of the lamps). Those lamps were placed horizontally along the support with a reflecting screen behind it. In addition two small quartz lamps with a reflecting screens behind it, were used at the edges, in order to reduce temperature differences between the middle and the edges of the plate. These lamps were arranged in such a way that an angle was made of 60° with the large longitudinal quartz lamp.

In another experiment a battery of small infrared lamps that are separately adressable were used as heating system (40). The power of each lamp was steered by an automatic back-coupling to the measured temperature (38). In this way a satisfying temperature profile could be obtained over the whole width of the substrate.

In order to provide efficient heating, the support was surrounded by a reflector cage (10) for preventing loss of heat radiation. That reflector cage (10) was made of reflecting material (aluminum in this case), taking into account spatial limitations and bypassing obstacles as much as possible.

In order to overcome excessive temperature increase while depositing vaporised phosphor or scintillator material, the substrate was cooled, by means of an adressable cooling unit (39), installed along and over the full width of the support. The cooling unit was addressable as it could be made effective or not by "switching" in an "on" or "off" position. Therefore it was build up of a black body cooling element, cooled with water at room temperature on the backside, and of an addressable (opened, closed) screen of louvers (multiple slats) on the front or support side. The slats were placed with their long side along the moving direction of the support, partly overlapping each other, providing ability to be reflective on the front side, and ability to become rotated altogether along their long axis. In the "cooling-off" position ("closed" position) the reflecting surface of the slats were directed towards the support in order to keep the heat preserved in the support, whereas in the "cooling-on" position the slats were rotated altogether over 90° in order to open the screen, so that the cool black body behind the screen could provide cooling of the support.

A CsBr:Eu stimulable phosphor layer having an average thickness of 640 µm was, within a time of 45 minutes, deposited over the entire length of the support in successive steps, during which the thickness of the deposited layer was increasing. Each site of the support was successively passing more times the vapour stream over the refractory boat or tray. The layer was thereby growing with an increasing thickness per each rotation, wherein said increasing thickness was measured on-line by a thickness measuring apparatus (22), based on capacitance measurements: changes in capacitance were introduced by the growing phosphor layer, measured between 2 electrodes (one of which, connected with the upper carrier roll was set on ground potential). As a result, in order to give an idea about homogeneity of the deposited layer onto the support, a variety in thicknesses in the range between 594 µm and 691 µm was obtained over the whole width thereof.

The stimulable phosphor layer was showing a blue luminescence under UV radiation again.

Panels having the desired size, as e.g. 35 cm x 45cm, were cut out of the above described large plate with a good edge quality. The cut panels were then laminated against a rigid flat glass plate without damage of the layer, making use therefor of a transferable adhesive.

In the same way as described hereinbefore sizes of the vacuum deposited plates were increased up to an area of more than 2 m² by increasing the length of the anodised aluminum support to more than 2.74 m. This was performed by increasing the diameter of the support roller (6) from 0.4 m to 0.9 m.

### Example 2

Same experiments were performed as in the inventive Example 1, except for the temporary protection, after the deposition of the needle-shaped phosphor imaging layer, by a laminate, provided by lamination of said imaging layer in vacuum. In this way the material was protected in order to be safely moved out of the vacuum chamber. The material could also be cut in the presence of the laminate so that contamination with debri or dust was made impossible. After cutting, the temporary protection laminate was removed by delamination. During delamination, debri or dust, present on the cutting edges, stuck to the laminate and did not contaminate the material.

### Example 3

Same experiments were performed as in the inventive Example 1, except for the protection, after the deposition of the needle-shaped phosphor imaging layer, by a laminate, provided by lamination in vacuum of said imaging layer with a lasting protection layer, originating from a lamination package. In this experiment the lamination package was consisting of a siliconised polyethylene terephthalate release layer (46), an adhesive layer and the protection foil. The lamination package was passing the laminate unit (36) with mechanism for supplying laminate foil and the protective foil was delaminated from the release layer (46) (siliconised polyethylene terephthalate) to become laminated onto the vapour deposited phosphor layer. As this operation proceeded in vacuum the phosphor layer was remaining dust free. The release layer (46) was further guided over the guiding rollers (45) to the same delamination collecting roller as used for delamination of the initial laminate (29) present on the protected substrate support (5).

The sheet or panel protected with the lasting protective layer could further be cut in the presence of the lasting protective laminate layer so that contamination with debri or dust was made impossible.

Having described in detail preferred embodiments of the current invention, it will now be apparent to those skilled in the art that numerous modifications can be made therein without departing from the scope of the invention as defined in the appending claims.

### PARTS LIST

- (1): vacuum chamber
- (2): oven
- (3): crucible, tray or boat
- (4): mixture of raw materials
- (5): sheet
- (6): conveying carrier roller
- (7): thermal isolation layer
- (8): cylindrical springs
- (9): infrared heater
- (10): reflector cage
- (11): pyrometer
- (12): baffle
- (13): baffle
- (14): metallic raster
- (15): separation plates
- (16): vapour stream
- (17): baffle
- (18): evaporation part
- (19): heating part
- (20): upper conveying carrier roller
- (21): travelling pathway
- (22): thickness measuring system
- (23): unwinding roller (supplying laminate roller)
- (24): upwinding roller (collecting initial laminated protective foil on substrate)
- (25): crucible container
- (26): internally heated chimney
- (27): controllable outlet
- (28): chimney heaters
- (29): initial delaminated protection foil
- (30): (optionally vacuum) suction table
- (31): pressure regulating cylinder(s)
- (32): optical positioning sensor
- (33): delamination collecting roller for delaminate foil (for initial laminate on substrate, and, optionally for release layer of lamination package for laminating deposited phosphor or scintillator layer)
- (34): delamination forerunner
- (35): delamination rollers
- (36): lamination unit to apply protection foil after vapour deposition
- (37): protection foil to be laminated after vapour deposition step
- (38): pyrometers
- (39): cooling unit
- (40): heating system
- (41): heat shield with slit
- (42): gas inlet
- (43): thermocouples
- (44): protected thermocouples
- (45): guiding rollers
- (46): laminate release foil (optional) ■

## Claims

1. A method for preparing a plurality of phosphor or scintillator sheets or panels having flexible supports or substrates (5) by continuously on-line coating a phosphor or scintillator layer within a sealed zone (1), wherein said zone comprises at least two cylindrical carrier rollers (6, 20) for carrying a flexible substrate (5) exceeding dimensional formats of desired phosphor or scintillator sheets or panels (5) with a factor of at least 5, wherein said cylindrical carrier rollers (6, 20) each have an axis in a parallel arrangement with one another; wherein said zone comprises at least one crucible (3) containing a mixture of raw materials (4) providing desired phosphor or scintillator compositions for said layer; and wherein said zone comprises a laminating unit (36); wherein said method comprises the steps of mounting said flexible substrate (5) onto said carrier rollers (6, 20), vapour depositing said phosphor or scintillator layer having a desired phosphor or scintillator composition onto said flexible substrate (5), and laminating said phosphor or scintillator layer, thereby covering said layer with a protective foil (37); further comprising the step of cutting said layer into sheets or panels having desired formats, and wherein at least during said vapour depositing step said zone is maintained under vacuum conditions as a vacuum chamber (1).

2. Method according to claim 1, wherein said zone further comprises a delaminating unit (33,34,35), and wherein a step of delaminating said flexible substrate (5), when provided with an initial protective laminate foil (37), is included, before said step of vapour depositing said phosphor or scintillator composition.

3. Method according to claim 1 or 2 wherein said steps of laminating said phosphor or scintillator layer and said step of delaminating said flexible substrate (5) are both performed under vacuum conditions.

4. Method according to any one of the claims 1 to 3, wherein said flexible substrate (5) support is an anodised aluminum support layer, covered with a protective foil.

5. Method according to claim 4, wherein said anodised aluminum support layer has a thickness in the range of from 50 to 500 µm.

6. Method according to any one of the claims 1 to 5, wherein in said mounting step two ends of the substrate support (5) are glued together with a heat resistant adhesive, with one or more rivets or with a combination thereof.

7. Method according to any one of the claims 1 to 6, wherein one carrier roller (6) is rotating, in a controlled way, by means of a motor around its axis, whereas other roller(s) (20) is (are) rotating by movement of said one roller (6); and wherein while rotating, the position of the flexible substate on the rollers is controlled by means of an optical positioning sensor (32), coupled back to pressure regulating cylinder(s) (31), providing position adjustment of said flexible substrate (5).

8. Method according to any one of the claims 2 to 7, wherein said protective laminate foil (29), initially laminated onto the said flexible substrate (5), is removed in said delaminating step, once said flexible substrate (5) has been put on tension.

9. Method according to claim 8, wherein said protective laminate foil (29) is removed under vacuum by delamination, making use of a delamination unit (33,34,35) present in the vacuum chamber (1).

10. Method according to any one of the claims 1 to 9, wherein said carrier rollers (6) are thermally isolated from said flexible substrate support (5) by means of a thermal isolation layer (7) and/or a plurality of heat-resistant coiled springs (8), mounted over the length of the cylinders in such a way that the said coiled springs (8) make an angle in the range of 20° to 40° with a line, parallel with the axis of said cylindrical carrier rollers (6, 20).

11. Method according to any one of the claims 1 to 10, wherein during said vapour depositing step the temperature of the said flexible substrate (5) is maintained in the range from 150°C to 300°C by means of regulable heaters (38,40) and by an adressable cooling unit (39) installed along the support.

12. Method according to claim 11, wherein said cooling unit (39) is build up of a black body cooling element, cooled with water at room temperature on the backside, and of an addressable (opened or closed) screen of louvers in form of multiple slats on the front or support side of said cooling element.

13. Method according to claim 11 or 12, wherein said temperature is measured over the whole width of said flexible substrate (5) by means of a set of pyrometers (38).

14. Method according to any one of the claims 11 to 13, wherein said temperature is measured and registrated and wherein a temperature profile over the whole width of said flexible substrate (5) is used as input for steering substrate heating and/or substrate cooling.

15. Method according to any one of the claims 1 to 14, wherein said sealed zone further comprises as a controlling part a thickness measuring system (22) determining thickness while vapour depositing said scintillator or phosphor layer, wherein said measuring system is based on capacitance measurements.

16. Method according to any one of the claims 1 to 15, wherein the said flexible substrate (5) is spatially surrounded by a reflector cage for heat radiation.

17. Method according to any one of the claims 1 to 16, wherein said protective foil (37), provided by the step of laminating said foil after depositing said phosphor or scintillator layer is a temporary protection layer (46) removed by a delaminating step before or after cutting; or a lasting protective foil layer (37).

18. Method according to any one of the claims 1 to 16, wherein said protective foil (37), provided by the step of laminating said foil after depositing said phosphor or scintillator layer is a lasting protection layer, wherein said lasting protection layer is provided from a protection layer package, comprising a release layer (46) that is removed in a further delaminating step and that is winded up on an upwinding roller (24).

19. Method according to any one of the claims 2 to 16, wherein said protective foil (37), provided by the step of laminating said foil after depositing said phosphor or scintillator layer is a lasting protection layer, wherein said lasting protection layer is provided from a protection layer package (23), comprising a release layer (46) removed in a further delaminating step by means of the same delaminating unit (33,34,35) used during the delaminating step of said flexible substrate (5) when initially provided with a protective laminate foil (29).

20. Method according to any one of the claims 1 to 19, wherein cutting said flexible substrate (5), coated with a phosphor or scintillator layer into sheets or panels having desired formats, proceeds out of the vacuum chamber (1).

21. Method according to any one of the claims 1 to 20, further **characterized by** the step of laminating said sheet or panel substrate (5) carrying said phosphor or scintillator layer onto a carrier layer (6).

22. Method according to claim 21, wherein said carrier layer (6) is selected from the group consisting of a flexible or rigid polymer layer, a glass support, a carbon fibre plate and a rigid metal sheet.

23. Method according to any one of the claims 1 to 22, wherein said step of vapour depositing said phosphor or scintillator compositions is initiated by a vapour flow (16) of raw materials (4) from one or more crucible(s) (3), and wherein said vapour flow (16) is generated by adding energy to said raw materials and said container(s), by thermal, electric, or electromagnetic energy or a combination thereof.

24. Method according to any one of the claims 1 to 22, wherein said step of vapour depositing said phosphor or scintillator compositions proceeds by physical vapour deposition, by chemical vapour deposition or a by combination of physical and chemical vapour deposition.

25. Method according to any one of the claims 1 to 24, wherein said raw materials comprise, as phosphor precursors, at least CsₓEu_{y}X'_{x+αy}, wherein the ratio of x to y exceeds a value of 0.25, wherein α ≥ 2 and wherein X' is a halide selected from the group consisting of Cl, Br and I and combinations thereof.

26. Method according to any one of the claims 1 to 24, wherein said raw materials comprise, as phosphor precursors, at least CsBr and CsₓEu_{y}X'_{x+αy}, wherein the ratio of x to y exceeds a value of 0.25, wherein α ≥ 2 and wherein X' is a halide selected from the group consisting of Cl, Br and I and combinations thereof.

27. Method according to any one of the claims 1 to 26, wherein wherein said phosphor layer is a binderless layer of a photostimulable CsBr:Eu phosphor.

## Patentansprüche

1. Ein Verfahren zur Herstellung mehrerer Leuchtstoff- oder Szintillatorfolien oder -platten mit biegsamen Trägern oder Substraten (5) durch kontinuierlichen On-line-Auftrag einer Leuchtstoff- oder Szintillatorschicht innerhalb eines Dichtbereichs (1), wobei dieser Bereich zumindest zwei zylindrische Tragrollen (6, 20) umfasst, die ein biegsames Substrat (5), dessen Format die Größe erwünschter Leuchtstoff- oder Szintillatorfolien oder -platten (5) um zumindest einen Faktor 5 übersteigt, tragen, wobei die Achsen der zylindrischen Tragrollen (6, 20) parallel zueinander ausgerichtet sind, wobei der Bereich zumindest einen Schmelztiegel (3), der ein Gemisch aus Rohmaterialien (4) zur Erzeugung erwünschter Leuchtstoff- oder Szintillatorzusammensetzungen für die besagte Schicht enthält, umfasst und wobei der Bereich eine Laminiereinheit (36) umfasst, wobei das Verfahren die Schritte der Befestigung des biegsamen Substrats (5) auf die Tragrollen (6, 20), der Aufdampfung der Leuchtstoff- oder Szintillatorschicht mit erwünschter Leuchtstoff- oder Szintillatorzusammensetzung auf das biegsame Substrat (5) und der Laminierung der Leuchtstoff- oder Szintillatorschicht, bei der die Schicht mit einer Schutzfolie (37) überzogen wird, umfasst und ferner den Schritt umfasst, in dem die Schicht in Folien oder Platten mit erwünschten Formaten zerschnitten wird, und wobei der Bereich zumindest während des Aufdampfungsschritts wie eine Vakuumkammer (1) unter Vakuumbedingungen gehalten wird.

2. Verfahren nach Anspruch 1, **dadurch gekennzeichnet, dass** der Bereich ferner eine Delaminiereinheit (33, 34, 35) umfasst und ein Schritt vorgesehen ist, in dem das biegsame Substrat (5), falls es zu Beginn mit einer Schutzlaminatfolie (37) kaschiert worden ist, zunächst abgespalten wird, ehe der Schritt der Aufdampfung der Leuchtstoff- oder Szintillatorzusammensetzung durchgeführt wird.

3. Verfahren nach Anspruch 1 oder 2, **dadurch gekennzeichnet, dass** die Schritte der Auflaminierung der Leuchtstoff- oder Szintillatorschicht und der Delaminierung des biegsamen Substrats (5) beide unter Vakuumbedingungen durchgeführt werden.

4. Verfahren nach einem der Ansprüche 1 bis 3, **dadurch gekennzeichnet, dass** der biegsame Substratträger (5) eine mit einer Schutzfolie bedeckte anodisierte Aluminiumträgerschicht ist.

5. Verfahren nach Anspruch 4, **dadurch gekennzeichnet, dass** die anodisierte Aluminiumträgerschicht eine Stärke zwischen 50 und 500 µm aufweist.

6. Verfahren nach einem der Ansprüche 1 bis 5, **dadurch gekennzeichnet, dass** während des Befestigungsschritts zwei Enden des Substratträgers (5) mittels eines hitzebeständigen Klebemittels, eines oder mehrerer Niete oder einer Kombination beider Befestigungsmittel miteinander verleimt werden.

7. Verfahren nach einem der Ansprüche 1 bis 6, **dadurch gekennzeichnet, dass** eine Tragrolle (6) in gesteuerter Weise mittels eines Motors um ihre Achse gedreht wird, während eine oder mehrere andere Walzen (20) durch die Bewegung der besagten einen Walze (6) gedreht werden, und die Position des biegsamen Substrats auf den sich drehenden Walzen mittels eines optischen, an einen oder mehrere Druckregelzylinder (31) rückgekoppelten und die Position des biegsamen Substrats (5) einstellenden Positionierungssensors (32) gesteuert wird.

8. Verfahren nach einem der Ansprüche 2 bis 7, **dadurch gekennzeichnet, dass** die zu Beginn auf dem biegsamen Substrat (5) auflaminierte Schutzlaminatfolie (29) im Delaminierungsschritt, wenn einmal das biegsame Substrat (5) unter Druck gebracht worden ist, entfernt wird.

9. Verfahren nach Anspruch 8, **dadurch gekennzeichnet, dass** die Schutzlaminatfolie (29) unter Verwendung einer in der Vakuumkammer (1) angeordneten Delaminiereinheit (33, 34, 35) unter Vakuum durch Delaminierung entfernt wird.

10. Verfahren nach einem der Ansprüche 1 bis 9, **dadurch gekennzeichnet, dass** die Tragrollen (6) mittels einer Wärmeisolationsschicht (7) und/oder mehrerer hitzebeständiger Spiralfedern (8) thermisch vom biegsamen Substratträger (5) isoliert sind, wobei die Spiralfedern (8) derart über die Länge der Zylinder befestigt sind, dass sie einen Winkel zwischen 20° und 40° zu einer parallel zur Achse der zylindrischen Tragrollen (6, 20) verlaufenden Linie bilden.

11. Verfahren nach einem der Ansprüche 1 bis 10, **dadurch gekennzeichnet, dass** die Temperatur des biegsamen Substrats (5) während des Aufdampfungsschritts mittels regelbarer Heizkörper (38, 40) und einer ansteuerbaren Kühleinheit (39), die beide am Träger entlang angeordnet sind, auf einen Wert zwischen 150°C und 300°C gehalten wird.

12. Verfahren nach Anspruch 11, **dadurch gekennzeichnet, dass** die Kühleinheit (39) aus einem an dessen Rückseite mit Wasser auf Zimmertemperatur abgekühlten Schwarzkörper-Kühlelement und einem ansteuerbaren (offenen oder geschlossenen) Schirm von Schlitzen in Form von mehreren, auf der Vorderseite oder Trägerseite des Kühlelements befindlichen Latten aufgebaut ist.

13. Verfahren nach Anspruch 11 oder 12, **dadurch gekennzeichnet, dass** die Temperatur mittels eines Satzes von Pyrometern (38) über die ganze Breite des biegsamen Substrats (5) gemessen wird.

14. Verfahren nach einem der Ansprüche 11 bis 13, **dadurch gekennzeichnet, dass** die Temperatur gemessen und aufgezeichnet und ein Temperaturprofil über die ganze Breite des biegsamen Substrats (5) als Eingangswert für die Steuerung der Substraterwärmung und/oder Substratabkühlung verwendet wird.

15. Verfahren nach einem der Ansprüche 1 bis 14, **dadurch gekennzeichnet, dass** der Dichtbereich ferner als Kontrollmittel ein Stärkemesssystem (22), das die Stärke der Szintillator- oder Leuchtstoffschicht wahrend deren Aufdampfung misst, umfasst, wobei das Stärkemesssystem auf Kapazitätsmessungen basiert.

16. Verfahren nach einem der Ansprüche 1 bis 15, **dadurch gekennzeichnet, dass** das biegsame Substrat (5) räumlich durch einen Reflektorkäfig für Hitzestrahlung umgeben ist.

17. Verfahren nach einem der Ansprüche 1 bis 16, **dadurch gekennzeichnet, dass** die Schutzfolie (37), die erhalten ist im Schritt, in dem die Folie auf der aufgedampften Leuchtstoff- oder Szintillatorschicht auflaminiert wird, eine zeitweilige Schutzschicht (46) ist, die vor oder nach dem Zerschneiden während eines Delaminierungsschritts entfernt wird, oder aber eine permanente Schutzfolienschicht (37).

18. Verfahren nach einem der Ansprüche 1 bis 16, **dadurch gekennzeichnet, dass** die Schutzfolie (37), die erhalten ist im Schritt, in dem die Folie auf der aufgedampften Leuchtstoff- oder Szintillatorschicht auflaminiert wird, eine permanente Schutzschicht ist, wobei diese permanente Schutzschicht aus einem Schutzschichtverband erhalten wird, der eine Trennschicht (46) umfasst, die in einem weiteren Delaminierungsschritt entfernt und auf eine Aufwickelrolle (24) aufgewickelt wird.

19. Verfahren nach einem der Ansprüche 2 bis 16, **dadurch gekennzeichnet, dass** die Schutzfolie (37), die erhalten ist im Schritt, in dem die Folie auf der aufgedampften Leuchtstoff- oder Szintillatorschicht auflaminiert wird, eine permanente Schutzschicht ist, wobei diese permanente Schutzschicht aus einem Schutzschichtverband (23) erhalten wird, der eine Trennschicht (46) umfasst, die in einem weiteren Delaminierungsschritt mittels der gleichen Delaminiereinheit (33, 34, 35) entfernt wird, die auch im Delaminierungsschritt des biegsamen Substrats (5) benutzt wird, falls das Substrat zu Beginn mit einer Schutzlaminatfolie (29) überzogen worden ist.

20. Verfahren nach einem der Ansprüche 1 bis 19, **dadurch gekennzeichnet, dass** das Zerschneiden des mit einer Leuchtstoff- oder Szintillatorschicht versehenen biegsamen Substrats (5) in Bogen oder Platten mit erwünschten Formaten außerhalb der Vakuumkammer (1) stattfindet.

21. Verfahren nach einem der Ansprüche 1 bis 20, ferner **gekennzeichnet durch** den Schritt, in dem das mit der Leuchtstoff- oder Szintillatorschicht versehene Bogen- oder Plattensubstrat (5) auf einer Trägerschicht (6) auflaminiert wird.

22. Verfahren nach Anspruch 21, **dadurch gekennzeichnet, dass** die Trägerschicht (6) aus der Gruppe bestehend aus einer Schicht aus biegsamem oder hartem Polymer, einem Glasträger, einer Kohlefaserplatte und einer harten Metallfolie gewählt wird.

23. Verfahren nach einem der Ansprüche 1 bis 22, **dadurch gekennzeichnet, dass** der Schritt der Aufdampfung der Leuchtstoff- oder Szintillatorzusammensetzungen durch einen Dampfstrom (16) von Rohmaterialien (4) aus einem oder mehreren Schmelztiegeln (3) initiiert wird und der Dampfstrom (16) durch Beaufschlagung der Rohmaterialien und des (der) Behälter(s) mit thermischer Energie, elektrischer Energie, elektromagnetischer Energie oder einer Kombination derselben erzeugt wird.

24. Verfahren nach einem der Ansprüche 1 bis 22, **dadurch gekennzeichnet, dass** der Schritt der Aufdampfung der Leuchtstoff- oder Szintillatorzusammensetzungen durch physikalische Gasphasenabscheidung, chemische Gasphasenabscheidung oder eine Kombination einer physikalischen Gasphasenabscheidung und einer chemischen Gasphasenabscheidung erfolgt.

25. Verfahren nach einem der Ansprüche 1 bis 24, **dadurch gekennzeichnet, dass** bei den Rohmaterialien als Leuchtstoffvorstufen zumindest CsₓEu_{y}X'_{x+αy}, wobei das Verhältnis von x zu y mehr als 0,25 beträgt, α ≥ 2 und X' ein Halogenid aus der Gruppe bestehend aus Cl, Br, I und Kombinationen derselben ist, verwendet wird.

26. Verfahren nach einem der Ansprüche 1 bis 24, **dadurch gekennzeichnet, dass** bei den Rohmaterialien als Leuchtstoffvorstufen zumindest CsBr und CsₓEu_{y}X'_{x+αy}, wobei das Verhältnis von x zu y mehr als 0,25 beträgt, α ≥ 2 und X' ein Halogenid aus der Gruppe bestehend aus Cl, Br, I und Kombinationen derselben ist, verwendet werden.

27. Verfahren nach einem der Ansprüche 1 bis 26, **dadurch gekennzeichnet, dass** die Leuchtstoffschicht eine bindemittelfreie Schicht aus einem ausleuchtbaren CsBr:Eu-Leuchtstoff ist.

## Revendications

1. Procédé pour préparer plusieurs feuilles ou panneaux fluorescents ou scintillants possédant des substrats ou des supports flexibles, par enduction d'une couche fluorescente ou scintillante au sein d'une zone fermée de manière hermétique, dans lequel ladite zone comprend au moins deux rouleaux de supports cylindriques pour transporter un substrat flexible dépassant les formats dimensionnels de feuilles ou de panneaux fluorescents ou scintillants désirés d'un facteur d'au moins 5, lesdits rouleaux de supports cylindriques possédant des axes disposés en arrangement parallèle les uns par rapport aux autres ; dans lequel ladite zone comprend au moins un creuset contenant un mélange de matières premières procurant des compositions fluorescentes ou scintillantes désirées pour ladite couche ; et dans lequel ladite zone comprend une unité de stratification, ledit procédé comprenant les étapes consistant à : monter ledit substrat flexible sur lesdits rouleaux de support ; déposer en phase vapeur ladite couche fluorescente ou scintillante possédant une composition fluorescente ou scintillante désirée sur ledit substrat flexible ; et stratifier ladite couche fluorescente ou scintillante, pour ainsi recouvrir ladite couche d'une mince feuille de protection ; le procédé comprenant en outre l'étape consistant à découper ladite couche en feuilles ou en panneaux possédant des formats désirés ; et dans lequel, au moins au cours de ladite étape de dépôt en phase vapeur, ladite zone est maintenue dans des conditions de vide par exemple via une chambre de vide.

2. Procédé selon la revendication 1, dans lequel ladite zone comprend en outre une unité de délamination, et dans lequel une étape de délamination dudit substrat flexible, lorsqu'il est muni d'une feuille mince de stratification protectrice initiale, est incluse, avant de passer à ladite étape de déposition en phase vapeur de ladite composition fluorescente ou scintillante.

3. Procédé selon la revendication 1 ou 2, dans lequel ladite étape de stratification de ladite couche fluorescente ou scintillante et ladite étape de délamination dudit substrat flexible sont toutes deux mises en oeuvre dans des conditions de vide.

4. Procédé selon l'une quelconque des revendications 1 à 3, dans lequel ledit support flexible faisant office de substrat est une couche de support en aluminium anodisé, recouverte d'une mince feuille de protection.

5. Procédé selon la revendication 4, dans lequel ladite couche de support en aluminium anodisé possède une épaisseur de la plage de 50 à 500 µm.

6. Procédé selon l'une quelconque des revendications 1 à 5, dans lequel, au cours de ladite étape de montage, deux extrémités du support faisant office de substrat sont collées l'une à l'autre avec un adhésif résistant à la chaleur, avec un ou plusieurs rivets ou avec une combinaison des deux.

7. Procédé selon l'une quelconque des revendications 1 à 6, dans lequel on soumet un rouleau de support à une rotation, de manière contrôlée, au moyen d'un moteur autour de son axe, tandis que l'autre/les autres rouleaux est/sont mis en rotation par le mouvement dudit premier rouleau ; et dans lequel, lors de la rotation, la position du substrat flexible sur les rouleaux est réglée au moyen d'un capteur de positionnement optique, couplé en retour à un ou plusieurs cylindres de régulation de la pression, afin de procurer un réglage de la position dudit substrat flexible.

8. Procédé selon l'une quelconque des revendications 2 à 7, dans lequel ladite mince feuille stratifiée de protection, stratifiée dans un premier temps sur ledit substrat flexible, est retirée au cours de ladite étape de délamination une fois que ledit substrat flexible a été mis sous tension.

9. Procédé selon la revendication 8, dans lequel ladite mince feuille stratifiée de protection est retirée sous vide par délamination, en utilisant une unité de délamination présente dans la chambre de vide.

10. Procédé selon l'une quelconque des revendications 1 à 9, dans lequel lesdits rouleaux de supports sont isolés du point de vue thermique par rapport audit support faisant office de substrat flexible au moyen d'une couche d'isolation thermique et/ou au moyen de plusieurs ressorts hélicoïdaux résistant à la chaleur, montée sur la longueur des cylindres de telle sorte que lesdits ressorts hélicoïdaux formant un angle dans la plage de 20° à 40° avec une ligne parallèle à l'axe desdits rouleaux de support cylindriques.

11. Procédé selon l'une quelconque des revendications 1 à 10, dans lequel, au cours de ladite étape de déposition en phase vapeur, la température dudit substrat flexible est maintenue dans la plage de 150 °C à 300 °C au moyen de dispositifs de chauffage qui peuvent être régulés et via une unité de refroidissement réglable qui est installée le long du support.

12. Procédé selon la revendication1 11, dans lequel ladite unité de refroidissement est obtenue à partir d'un élément de refroidissement constitué par une boîte noire refroidie avec de l'eau à la température ambiante sur son côté dorsal et par un écran réglable de volets (qui peuvent être ouverts ou fermés) sous la forme de multiples orifices pratiqués dans le côté frontal ou dans le côté de support dudit élément de refroidissement.

13. Procédé selon la revendication 11 ou 12, dans lequel ladite température mesurée sur toute la largeur dudit substrat flexible au moyen d'un jeu de pyromètres.

14. Procédé selon l'une quelconque des revendications 11 à 13, dans lequel ladite température est mesurée et est enregistrée, et dans lequel un profil de température sur toute la largeur dudit substrat flexible est utilisé comme entrée pour régler le chauffage du substrat et/ou le refroidissement du substrat.

15. Procédé selon l'une quelconque des revendications 1 à 14, dans lequel ladite zone fermée de manière hermétique comprend, à titre d'élément de réglage, un système de mesure de l'épaisseur, qui détermine l'épaisseur lors de la déposition en phase vapeur de ladite couche scintillante ou fluorescente, ledit système de mesure étant basé sur la mesure de la capacitance.

16. Procédé selon l'une quelconque des revendications 1 à 15, dans lequel ledit substrat flexible est entouré dans l'espace par une cage de réflexion pour le rayonnement de la chaleur.

17. Procédé selon l'une quelconque des revendications 1 à 16, dans lequel ladite mince feuille de protection, que l'on applique via l'étape de stratification de ladite mince feuille après déposition de ladite couche fluorescente ou scintillante, représente une couche de protection temporaire éliminée par l'étape de délamination avant ou après la découpe.

18. Procédé selon l'une quelconque des revendications 1 à 16, dans lequel ladite mince feuille de protection, que l'on applique via l'étape de stratification de ladite mince feuille après déposition de ladite couche fluorescente ou scintillante, représente une couche de protection qui dure, ladite couche de protection qui dure étant fournie à partir d'un paquet de couches de protection, comprenant une couche amovible qui est retirée lors d'une étape de délamination ultérieure pour venir s'enrouler sur un rouleau de réenroulement.

19. Procédé selon l'une quelconque des revendications 2 à 16, dans lequel ladite mince feuille de protection, que l'on applique via l'étape de stratification de ladite mince feuille après déposition de ladite couche fluorescente ou scintillante, représente une couche de protection qui dure, ladite couche de protection qui dure étant fournie à partir d'un paquet de couches de protection, comprenant une couche amovible qui est retirée lors d'une étape de délamination ultérieure en utilisant la même unité de délamination que celle utilisée au cours de l'étape de délamination dudit substrat flexible, lorsqu'il est muni à l'origine d'une mince feuille stratifiée de protection.

20. Procédé selon l'une quelconque des revendications 1 à 19, dans lequel la découpe dudit substrat flexible enduit d'une couche fluorescente
ou scintillante, pour obtenir des feuilles où des panneaux possédant des formats désirés, a lieu en dehors de la chambre de vide.

21. Procédé selon l'une quelconque des revendications 1 à 20,
**caractérisé en outre par** l'étape de délamination dudit substrat de feuille
ou de panneau supportant ladite couche fluorescente ou scintillante sur une couche de support.

22. Procédé selon la revendication 21, dans lequel ladite couche de support est choisie parmi le groupe constitué par une couche polymère rigide ou flexible, un support en verre, une plaque en fibres de verre ou encore une feuille de métal rigide.

23. Procédé selon l'une quelconque des revendications 1 à 22, dans lequel ladite étape de déposition en phase vapeur desdites compositions fluorescentes ou scintillantes est déclenchée par un écoulement de matières premières sous forme de vapeur à partir d'un ou de plusieurs creusets, ledit écoulement sous forme de vapeur étant généré par addition d'énergie auxdites matières premières et au(x)dit(s) récipient(s) par énergie thermique, électrique ou électromagnétique ou bien par une combinaison desdites énergies.

24. Procédé selon l'une quelconque des revendications 1 à 22, dans lequel ladite étape de déposition en phase vapeur desdites compositions fluorescentes ou scintillantes a lieu via une déposition physique en phase vapeur, via une déposition chimique en phase vapeur ou bien via une combinaison d'une déposition physique en phase vapeur et d'une déposition chimique en phase vapeur.

25. Procédé selon l'une quelconque des revendications 1 à 24, dans lequel lesdites matières premières comprennent, à titre de précurseurs de substances fluorescentes, au moins le composé CsₓEu_{y}X'_{x+αy}, le rapport de x à y dépassant une valeur de 0,25, procédé dans lequel α ≥ 2 et dans lequel X' représente un halogénure choisi parmi le groupe constitué par le chlore, le brome et l'iode, et leurs combinaisons.

26. Procédé selon l'une quelconque des revendications 1 à 24, dans lequel lesdites matières premières comprennent, à titre de précurseurs de substances fluorescentes, au moins du CsBr et le composé CsₓEu_{y}X'_{x+αy}, le rapport de x à y dépassant une valeur de 0,25, procédé dans lequel α ≥ 2 et dans lequel X' représente un halogénure choisi parmi le groupe constitué par le chlore, le brome et l'iode, et leurs combinaisons.

27. Procédé selon l'une quelconque des revendications 1 à 26, dans lequel ladite couche fluorescente est une couche exempte de liant d'un luminophore photostimulable à base de CsBr:Eu.
